# EUROPÄISCHE PATENTSCHRIFT

(11) **EP 4 700 395 B1**
(45) Veröffentlichungstag und Bekanntmachung des Hinweises auf die Patenterteilung: **30.09.2026**
(21) Anmeldenummer: 24195840.4
(22) Anmeldetag: 22.08.2024
(51) Int. Cl.: G01R 1/20, H01R 12/58, H05K 3/30, H05K 3/306, G01R 1/04

(54) **KONTAKTIERUNGSSYSTEM ZUR KONTAKTIERUNG EINER ELEKTRONISCHEN BAUGRUPPE MIT EINER LEITERPLATTE SOWIE MESSWIDERSTAND MIT EINEM SOLCHEN KONTAKTIERUNGSSYSTEM**
CONTACT SYSTEM FOR CONTACTING AN ELECTRONIC ASSEMBLY WITH A PRINTED CIRCUIT BOARD AND MEASURING RESISTOR WITH SUCH A CONTACT SYSTEM
SYSTÈME DE MISE EN CONTACT POUR METTRE EN CONTACT UN MODULE ÉLECTRONIQUE AVEC UNE CARTE DE CIRCUIT IMPRIMÉ ET RÉSISTANCE DE MESURE DOTÉE D'UN TEL SYSTÈME DE MISE EN CONTACT

(43) Veröffentlichungstag der Anmeldung: 25.02.2026
(73) Patentinhaber: Pollmann International GmbH, 3822 Karlstein an der Thaya (AT)
(72) Erfinder: MIKSCH, Christoph, 3822 Karlstein an der Thaya (AT)
(74) Vertreter: SONN Patentanwälte GmbH & Co KG

(56) Entgegenhaltungen:
- DE-A1- 102023 111 432
- DE-U1- 20 318 266
- US-A1- 2005 057 865
- US-A1- 2016 139 209

## Beschreibung

Die Erfindung betrifft ein Kontaktierungssystem zur Kontaktierung einer elektronischen Baugruppe mit einer Leiterplatte (Printed Circuit Board PCB), mit zumindest einem Kontaktelement mit jeweils einem ersten Ende zur Verbindung mit der elektronischen Baugruppe und jeweils einem zweiten Ende zur Verbindung mit der Leiterplatte, wobei das zumindest eine Kontaktelement zwischen dem ersten Ende und dem zweiten Ende einen in einer Richtung parallel zur elektronischen Baugruppe und der Leiterplatte verformbaren Bereich aufweist, zur Erzielung einer Verschiebbarkeit des ersten Endes relativ zum zweiten Ende des Kontaktelements in einer Richtung parallel zur elektronischen Baugruppe und der Leiterplatte.

Weiters betrifft die Erfindung einen Messwiderstand mit einem Präzisionswiderstand und beiderseits mit dem Präzisionswiderstand verbundenen Leiterelementen und einem oben erwähnten Kontaktierungssystem.

Die vorliegende Erfindung betrifft verschiedenste Anwendungen der Elektronik, wobei bestimmte elektronische Baugruppen, wie zum Beispiel elektronische Bauelemente, Sensoren oder Aktoren, mit einer Leiterplatte elektrisch leitend verbunden werden sollen. Beispielsweise werden bei Batterie-elektrischen Fahrzeugen zum Zweck der Regelung die Ströme der Drehstrommotoren gemessen und in entsprechenden elektronischen Schaltungen ausgewertet. Diese Messung kann einerseits mit Strommesszangen, welche die stromdurchflossenen Leiter umgeben, berührungslos erfolgen oder über Messwiderstände, sogenannte Shunts, der Spannungsabfall erfasst werden. Zu diesem Zweck werden an den Enden von Präzisionswiderständen (beispielsweise Plättchen aus Manganin^{®}, einer von der Isabellenhütte entwickelten Präzisions-Widerstandslegierung) Kontaktelemente befestigt, insbesondere angeschweißt oder angelötet und die jeweils anderen Enden der Kontaktelemente mit der Leiterplatte einer elektronischen Schaltung verbunden. Insbesondere bei automatisierten Kontaktierungsverfahren kommen vielfach sogenannte Press-Fit-Pins als Kontaktelemente zur Anwendung, welche zumindest an einem Ende komprimierbare Köpfe aufweisen, welche in entsprechende Durchgangsöffnungen bzw. Durchkontaktierungen in der Leiterplatte gesteckt werden können und auch ohne Löten oder Schweißen einen elektrischen Kontakt mit der Leiterplatte herstellen. Auch die anderen Enden der Press-Fit-Pins können mit komprimierbaren Köpfen versehen sein, welche in entsprechende Bohrungen im Messwiderstand eingesteckt werden können.

Beispielsweise beschreibt die DE 10 2014 207 759 A1 einen solchen Messwiderstand mit Durchgangsöffnungen für Press-Fit-Pins. Häufig ist die Position der elektronischen Baugruppe und der Leiterplatte fix vorgegeben, wodurch es bei nicht exakt angeordneten Kontaktelementen oder toleranzbedingten Größenunterschieden zu Problemen bei der Kontaktierung kommen kann. Insbesondere bei automatischen Fertigungen kann es zu unerwünschten Unterbrechungen kommen, weil die Kontaktelemente nicht in die dafür vorgesehenen Durchgangsöffnungen in der Leiterplatte gesteckt werden können. Dadurch kommt es zu teuren Stillständen der Fertigungsstraßen, notwendigen manuellen Nachbesserungen oder sogar Ausschuss.

Aber auch bei manuellen Kontaktierungen sind Toleranzen höchst unerwünscht und können zu Verzögerungen bei der Kontaktierung von Leiterplatten mit elektronischen Baugruppen führen.

Die US 2007/0200720 A1 beschreibt eine Vorrichtung zur Messung des Batteriestromes in einem Elektrofahrzeug, wobei ein Messwiderstand eines Stromsensors über abgewinkelte Kontaktelemente in Form von Press-Fit-Pins über entsprechende Durchgangsbohrungen mit der Leiterplatte einer Messschaltung verbunden werden kann. Zur Kompensation einer thermischen Ausdehnung sind die Kontaktelemente zwischen ihren Enden teilweise elastisch ausgebildet, wobei nicht angeführt wird, wie dieser elastische Bereich ausgeführt ist.

Aus der DE 10 2021 116 447 B4 gehen Press-Fit-Verbindungselemente zur Kontaktierung von Batteriemodulen hervor, die zwischen den Enden teilweise elastisch ausgebildet sein können, um Bewegungen der Batteriemodule kompensieren zu können.

Aus der DE 10 2023 111432 A1 ist eine Stromerfassungsvorrichtung bekannt, bei der ein Shunt-Widerstand über spezielle Verbindungsanschlüsse mit einem Substrat verbunden wird.

Die Vorrichtung umfasst ein Halteelement aus Harz, das die Verbindungsanschlüsse hält und für eine stabile mechanische und elektrische Verbindung sorgt.

Die Aufgabe der vorliegenden Erfindung besteht in der Schaffung eines oben genannten Kontaktierungssystems sowie eines Messwiderstands mit einem solchen Kontaktierungssystem, wodurch die Kontaktierung erleichtert werden kann und auch trotz toleranzbedingter Abweichungen der Größen und Positionen der Kontaktelemente zuverlässige Verbindungen zwischen der elektronischen Baugruppen und der Leiterplatte erzielt werden können. Dies soll sowohl bei automatisiert als auch manuell vorgenommenen Kontaktierungen funktionieren. Nachteile bekannter Systeme sollen vermieden oder zumindest reduziert werden. Das Kontaktierungssystem soll möglichst einfach und kostengünstig herstellbar sein, um eine breite Anwendung zu ermöglichen.

Gelöst wird die erfindungsgemäße Aufgabe durch ein oben genanntes Kontaktierungssystem, wobei das zumindest eine Kontaktelement von einer Einhausung aus elektrisch isolierendem Material umgeben und zur Fixierung des ersten Endes oder zweiten Endes des Kontaktelements ausgebildet ist und in einer Richtung parallel zur elektronischen Baugruppe und der Leiterplatte verschiebbar ist, und an der Einhausung zumindest ein über das erste Ende oder das zweite Ende jedes Kontaktelements überstehendes Positionierelement zur Anordnung in zumindest einer entsprechenden Positionieröffnung in der Leiterplatte oder der elektronischen Baugruppe angeordnet ist. Erfindungsgemäß wird also die Kontaktierung zwischen der elektronischen Baugruppe und einer Leiterplatte mit zumindest einem Kontaktelement mit einem verformbaren Bereich vorgenommen, wodurch die beiden Enden des Kontaktelements in einer Richtung parallel zur elektronischen Baugruppe und Leiterplatte gegeneinander verschoben werden können. Dadurch können Toleranzen ausgeglichen und Kontaktierungen zwischen der elektronischen Baugruppe und der Leiterplatte auch dann vorgenommen werden, wenn die Position der Kontaktelemente zur elektronischen Baugruppe einerseits und zur Leiterplatte andererseits nicht exakt stimmen. Zum Zweck des Anordnens oder Einfädelns der Kontaktelemente mit den verformbaren Bereichen an die dafür vorgesehenen Stellen in der Leiterplatte oder in der elektronischen Baugruppe wird das zumindest eine Kontaktelement von einer Einhausung mit zumindest einem Positionierelement umgeben und an einem Ende fixiert. Das Positionierelement steht über das Ende des Kontaktelements über und zwingt so das Ende des Kontaktelements an die vorgesehene Stelle, beispielsweise in die vorgesehene Durchgangsbohrung in der Leiterplatte oder an die entsprechende Kontaktstelle oder Lötporition. Das Positionierelement ist in Bezug auf das Kontaktelement entsprechend ausgerichtet, sodass bei Anordnung des Positionierelements in einer entsprechenden Positionieröffnung in der Leiterplatte oder der elektronischen Baugruppe das fixierte Ende des zumindest einen Kontaktelements an die dafür vorgesehene Stelle an der Leiterplatte oder der elektronischen Baugruppe gezwungen wird. Während des Kontaktiervorgangs werden allfällige toleranzbedingte Abweichungen der Position der Kontaktelemente durch Dehnung oder Stauchung des verformbaren Bereichs der Kontaktelemente ausgeglichen. Die erfindungsgemäße Konstruktion des Kontaktierungssystems ermöglicht eine Ausrichtung der Kontaktelemente bei fix vorgegebenen Positionen der elektronischen Baugruppe und Leiterplatte auch bei Abweichungen und erleichtert bzw. ermöglicht den Kontaktiervorgang insbesondere bei automatisierten Fertigungsstraßen. Die Erfindung bewirkt quasi eine selbstjustierende oder selbstpositionierende Kontaktierung des zumindest einen Kontaktelements zwischen der elektronischen Baugruppe und einer Leiterplatte. Das zumindest eine an der elektronischen Baugruppe fixierte Kontaktelement wird durch das erfindungsgemäße Kontaktierungssystem automatisch an die gewünschte(n) Stelle(n) der Leiterplatte positioniert und ausgerichtet. Natürlich kann das zumindest eine Kontaktelement auch umgekehrt zuerst mit dem zweiten Ende mit der Leiterplatte verbunden und erst dann mit dem ersten Ende und den entsprechend angeordneten Positionierelementen an der Einhausung mit der elektronischen Baugruppe verbunden werden. Kern der Erfindung ist der zumindest eine verformbare Bereich zwischen dem ersten und zweiten Ende der Kontaktelemente zusammen mit der Einhausung und dem zumindest einen Positionierelement. Die Einhausung kann die Form eines Gehäuses um das zumindest eine Kontaktelement oder auch nur eine das zumindest eine Kontaktelement umgebende Gitterstruktur aufweisen. Wesentlich ist die Fixierung eines Endes des Kontaktelements, um dieses während des Kontaktiervorgangs in eine definierte Lage in Bezug auf das an der Einhausung angeordnete zumindest eine Positionierelement zu bringen. Wenn während des Kontaktiervorgangs das fixierte Ende des zumindest einen Kontaktelements in die gewünschte Position auf der Leiterplatte gebracht wird, kann es zu einer Verformung des verformbaren Bereichs des zumindest einen Kontaktelements und somit zu einer Verschiebung des zweiten Endes des Kontaktelements gegenüber dem ersten Ende des Kontaktelements oder umgekehrt kommen. Neben der Funktion der Fixierung eines Endes des Kontaktelements kann die Einhausung auch eine Isolierung des Kontaktelements gegenüber umliegenden Teilen der elektronischen Baugruppe oder Leiterplatte bewirken. Aus diesem Grund ist die Einhausung aus einem elektrisch isolierenden Material, insbesondere einem geeigneten Kunststoff, gefertigt.

Vorteilhafterweise ist jedes Kontaktelement in einer Richtung senkrecht zur elektronischen Baugruppe und Leiterplatte fixiert. Dadurch kann das zumindest eine Kontaktelement in Bezug auf das oder die Positionierelement(e) in Richtung der zu kontaktierenden Leiterplatte fixiert werden. Die Fixierung kann durch Umspritzen der Einhausung um das zumindest eine Kontaktelement oder Vorsehen entsprechender Elemente an der Einhausung, wie Rastvorsprünge oder dgl., in welche entsprechende Teile der Kontaktelemente einrasten, realisiert werden.

Beispielsweise kann die Einhausung eine Aufnahme zur Fixierung des ersten Endes oder zweiten Endes des Kontaktelements aufweisen, in welche Aufnahme ein entsprechender Teil des jeweiligen Kontaktelements angeordnet werden kann, sodass das Kontaktelement in senkrechter Richtung zur elektronischen Baugruppe und Leiterplatte in der Einhausung fixiert wird. Bei Press-Fit-Pins eignen sich die Schultern unter dem komprimierbaren Kopf besonders für die Fixierung durch die Einhausung in z-Richtung.

Der verformbare Bereich jedes Kontaktelements kann beispielsweise durch einen in zumindest einer Ebene hin- und herverlaufend angeordneten Leiterabschnitt, vorzugsweise einem in zumindest einer Ebene mäanderförmig oder zick-zack-förmig verlaufenden Leiterabschnitt, gebildet sein, wodurch eine Verschiebbarkeit der beiden Enden des Kontaktelements gegeneinander in zumindest einer Richtung parallel zur elektronischen Baugruppe und der Leiterplatte erzielbar ist. Derartige Gestaltungen des verformbaren Bereichs der Kontaktelemente stellen nur einige der möglichen Varianten dar. Auch andere geometrische Gestaltungen oder auch Materialzusammensetzungen, welche eine Verformbarkeit zulassen, sind denkbar, wobei auf einfache und kostengünstige Herstellbarkeit geachtet werden soll.

Vorzugsweise ist jedes Kontaktelement durch Stanzen aus einem Metallblech besonders einfach und kostengünstig herstellbar. Mit dieser Variante der Kontaktelemente lassen sich die oben erwähnten geometrischen Varianten des verformbaren Bereichs besonders einfach herstellen.

Die Kontaktelemente können durch Press-Fit-Pins mit einem komprimierbaren Kopf an zumindest einem Ende gebildet sein. Derartige Press-Fit-Pins eignen sich für eine lötfreie Verbindungstechnik bei Leiterplatten besonders, da der komprimierbare Kopf beim Einbringen in eine Durchgangsbohrung bzw. Durchkontaktierung in einer Leiterplatte zusammengedrückt werden kann und durch die elastische Wirkung in der Durchkontaktierung hält. Press-Fit-Pins sind bei automatisierten Herstellungs- oder Bestückungsverfahren weit verbreitet.

Wenn die Einhausung zumindest aus zwei miteinander verbindbaren Teilen besteht, kann eine Fixierung eines Endes insbesondere mehrerer Kontaktelemente besonders rasch und einfach vorgenommen werden. Die zumindest zwei Teile der Einhausung können mit geeigneten Herstellungsverfahren, insbesondere Spritzgießverfahren, vorgefertigt werden und dann manuell oder automatisiert auf das zumindest eine Kontaktelement aufgebracht und miteinander verbunden werden.

Dabei ist es von Vorteil, wenn die Teile der Einhausung über Rastelemente werkzeuglos miteinander verbindbar sind. Dies ermöglicht eine rasche und einfache Herstellung des Kontaktierungssystems ohne zusätzliche Bauteile oder Werkstoffe, wie zum Beispiel Schrauben oder Klebstoffe.

Das zumindest eine Positionierelement an der Einhausung kann durch zumindest einen Positionierstift mit vorzugsweise eckigem Querschnitt gebildet sein. Wenn nur ein Positionierstift als Positionierelement vorgesehen ist, eignet sich ein eckiger Querschnitt, wie zum Beispiel ein dreieckiger, viereckiger oder mehreckiger Querschnitt besonders, um eine eindeutige Ausrichtung des zumindest einen Kontaktelements in Bezug auf die Leiterplatte (oder in Bezug auf die elektronische Baugruppe) zu erzielen. Die entsprechende Positionieröffnung in der Leiterplatte (oder elektronischen Baugruppe) weist eine an den Querschnitt des Positionierstifts angepasste Form auf. Bei einem Positionierstift mit quadratischem Querschnitt kann die Positionieröffnung in der Leiterplatte (oder elektronischen Baugruppe) beispielsweise die Form einer quadratischen Pyramide aufweisen, in welche der Positionierstift beim Kontaktiervorgang eingefädelt und schließlich in der gewünschten Position fixiert wird. Für ein leichteres Einfädeln des Positionierstifts in die Positionieröffnung kann das freie Ende des Positionierstifts auch zusammenlaufend bzw. angespitzt ausgeführt werden.

Alternativ dazu kann das zumindest eine Positionierelement auch durch zumindest zwei Positionierstifte mit vorzugsweise rundem Querschnitt gebildet sein. Bei zumindest zwei Positionierstiften ist für eine eindeutige Lage des Kontaktierungssystems in Bezug auf die Leiterplatte (oder elektronische Baugruppe) kein von der Kreisform abweichender Querschnitt erforderlich, weshalb die Positionierstifte runden Querschnitt aufweisen können. Die Positionieröffnungen an der Leiterplatte (oder elektronischen Baugruppe), in welche die Positionierstifte beim Kontaktiervorgang hineinragen, weisen dann runde oder Langloch-förmige und vorzugsweise zusammenlaufende Gestalt auf.

Wenn die Einhausung vorzugsweise zusammen mit den Positionierelementen aus Kunststoff, insbesondere aus thermoplastischem Kunststoff, hergestellt ist, kann eine kostengünstige und rasche Produktion erzielt werden. Dabei eignen sich Spritzgießverfahren mit geeigneten Materialien, wie zum Beispiel Polyamid (PA), Polyphthalamid (PPA), Polyphenylensulfid (PPS) oder Polybutylenterephthalat (PBT) besonders für die Herstellung der Einhausung und Positionierelemente.

Das erste Ende eines Kontaktelements kann durch einen abgeflachten Fuß zur Verbindung mit der elektronischen Baugruppe, vorzugsweise durch Schweißen oder Löten, gebildet sein. Ein abgeflachter Fuß des ersten Endes des Kontaktelements kann optimal mit einer entsprechenden Kontaktfläche auf der elektronischen Baugruppe verbunden und fixiert werden. Auch die Herstellung eines abgeflachten Fußes ist beispielsweise durch Stanzen aus einem entsprechenden Metallblech besonders einfach und kostengünstig möglich.

Weiters kann das erste Ende eines Kontaktelements und bzw. oder das zweite Ende eines Kontaktelements auch durch einen Lötpin zur Kontaktierung mit der elektronischen Baugruppe und bzw. oder der Leiterplatte, vorzugsweise durch Schweißen oder Löten, gebildet sein.

Schließlich kann das erste Ende eines Kontaktelements und bzw. oder das zweite Ende eines Kontaktelements auch durch einen komprimierbaren Kopf zur automatischen Kontaktierung in entsprechenden Durchgangsbohrungen in der elektronischen Baugruppe und bzw. oder der Leiterplatte gebildet werden. Derartige komprimierbare Köpfe sind beispielsweise bei den oben erwähnten Press-Fit-Pins vorgesehen. Auch Kombinationen verschieden gestalteter Enden der Kontaktelemente sind möglich.

Die Erfindung wird auch durch einen oben beschriebenen Messwiderstand mit einem Präzisionswiderstand und beiderseits mit dem Präzisionswiderstand verbundenen Leiterelementen gelöst, mit einem oben beschriebenen Kontaktierungssystem, wobei zwei Kontaktelemente mit ihrem ersten Ende mit den Leiterelementen des Präzisionswiderstands verbunden sind und mit ihrem zweiten Ende mit Durchgangsbohrungen einer Leiterplatte kontaktierbar sind. Auf diese Weise kann eine Strommessung mit einem Messwiderstand bzw. Shunt besonders einfach vorgenommen werden und die Kontaktierung der Leiterplatte einer Auswerteelektronik mit dem Messwiderstand rasch und einfach vorgenommen werden. Gewisse Toleranzen werden durch das erfindungsgemäße Kontaktierungssystem zugelassen. Zu den erzielbaren Vorteilen wird auf das oben beschriebene Kontaktierungssystem verwiesen.

Gemäß einem weiteren Merkmal der Erfindung sind die Kontaktelemente mit ihrem ersten Ende in Form eines abgeflachten Fußes oder Lötpins mit den Leiterelementen verschweißt oder verlötet. Mittels Schweißen oder Löten kann das erste Ende der Kontaktelemente besonders rasch mit den leitenden Teilen des Shunts verbunden werden.

Ebenso können die Kontaktelemente mit ihrem ersten Ende in Form eines komprimierbaren Kopfes eines Press-Fit-Pins mit Durchgangsbohrungen in den Leiterelementen verbindbar sein.

Die vorliegende Erfindung wird anhand der beigefügten Zeichnungen näher erläutert. Darin zeigen
- Fig. 1: ein Kontaktierungssystem zur Kontaktierung einer Leiterplatte mit einer elektronischen Baugruppe nach dem Stand der Technik;
- Fig. 2: das Kontaktierungssystem gemäß Fig. 1 beim Versuch der Kontaktierung der Leiterplatte mit der elektronischen Baugruppe;
- Fig. 3: ein Kontaktelement mit einem verformbaren Bereich zwischen den beiden Enden nach dem Stand der Technik;
- Fig. 4: eine Ausführungsform eines erfindungsgemäßen Kontaktierungssystems mit einem Kontaktelement;
- Fig. 5: das Kontaktierungssystem gemäß Fig. 4 beim Kontaktieren der Leiterplatte mit der elektronischen Baugruppe;
- Fig. 6: ein Detail der Einhausung in geschnittener Darstellung;
- Fig. 7: eine Ausführungsform eines erfindungsgemäßen Kontaktierungssystems mit zwei Kontaktelementen;
- Fig. 8: das Kontaktierungssystem gemäß Fig. 7 vor dem Kontaktiervorgang;
- Fig. 9: das Kontaktierungssystem gemäß Fig. 7 beim Kontaktieren der Leiterplatte mit der elektronischen Baugruppe; und
- Fig. 10A bis 10D: verschiedene Ausführungsvarianten der Kontaktelemente.

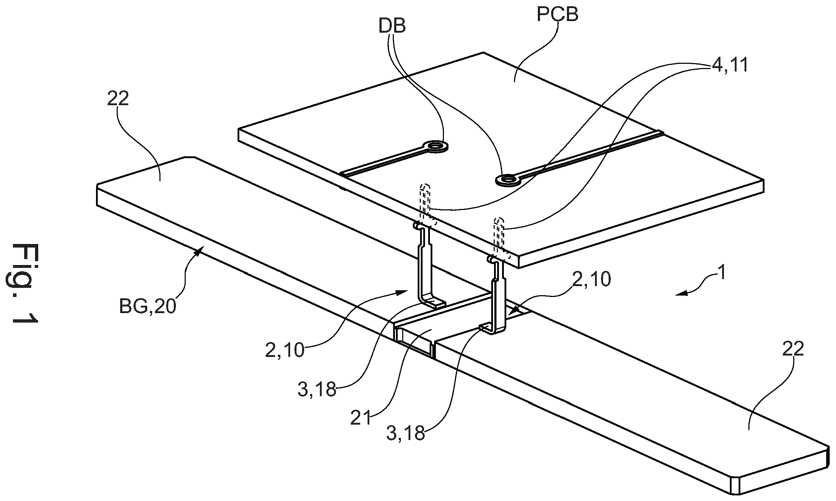

Fig. 1 zeigt ein Kontaktierungssystem 1 zur Kontaktierung einer Leiterplatte PCB mit einer elektronischen Baugruppe BG nach dem Stand der Technik. Die elektronische Baugruppe BG, welche mit der Leiterplatte PCB verbunden und kontaktiert werden soll, kann beispielsweise durch einen Messwiderstand 20 gebildet sein, der einen Präzisionswiderstand 21 aus geeignetem Material und damit verbundene Leiterelemente 22 aufweist. An den zum Präzisionswiderstand 21 weisenden Enden der Leiterelemente 22 werden jeweils Kontaktelemente 2 angeordnet, welche beispielsweise in Form von Press-Fit-Pins 10 ausgeführt sind. In diesem Beispiel hat das erste Ende 3 des Kontaktelements 2 zur Verbindung mit der elektronischen Baugruppe BG die Form eines abgeflachten Fußes 18 und das zweite Ende 4 des Kontaktelements 2 zur Verbindung mit der Leiterplatte PCB die Form eines komprimierbaren Kopfes 11, welcher in entsprechende Durchgangsbohrungen DB der Leiterplatte PCB eingebracht werden sollen.

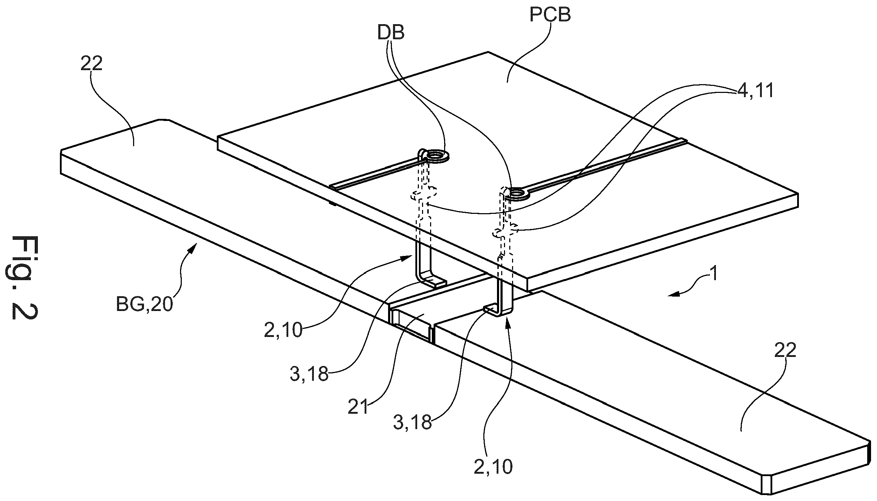

Fig. 2 zeigt das Kontaktierungssystem 1 gemäß Fig. 1 beim Versuch der Kontaktierung der Leiterplatte PCB mit der elektronischen Baugruppe BG. Stimmen die Positionen der zweiten Enden 4 der Kontaktelemente 2 nicht exakt mit den Positionen der vorgesehenen Duchgangsbohrungen DB in der Leiterplatte PCB überein, kann die Kontaktierung nicht vorgenommen werden. Durch manuelles Verbiegen der Kontaktelemente 2 kann unter Umständen eine Anordnung des zweiten Endes 4 bzw. komprimierbaren Kopfes 11 der Press-Fit-Pins 10 in den Durchgangsbohrungen DB der Leiterplatte PCB erreicht und dennoch eine Kontaktierung hergestellt werden. Bei zu großen Abweichungen der gewünschten Positionen der Kontaktelemente 2 wird eine Kontaktierung allerdings nicht möglich sein und die elektronische Baugruppe BG mit den daran angeordneten Kontaktelementen 2 muss unter Umständen verworfen werden.

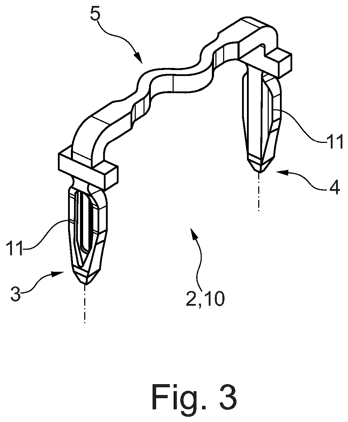

In Fig. 3 ist ein Kontaktelement 2 in Form eines Press-Fit-Pins 10 mit einem verformbaren Bereich 5 zwischen den beiden Enden 3, 4 nach dem Stand der Technik dargestellt. Durch diesen verformbaren Bereich 5 in Wellenform entsteht eine gewisse Elastizität und Verformbarkeit des Kontaktelements 2, wodurch Bewegungen der mit den Enden 3, 4 verbundenen Baugruppen (nicht dargestellt) kompensiert werden können.

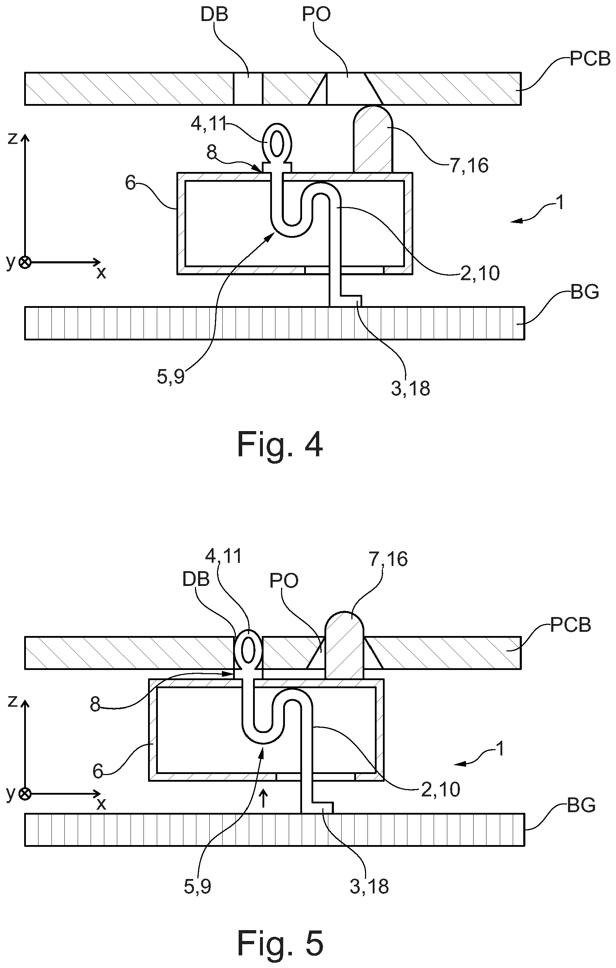

Fig. 4 zeigt eine Ausführungsform eines erfindungsgemäßen Kontaktierungssystems 1 mit einem Kontaktelement 2. Das Kontaktelement 2 weist ein erstes Ende 3 zur Verbindung mit der elektronischen Baugruppe BG und ein zweites Ende 4 zur Verbindung mit der Leiterplatte PCB auf. Zwischen dem ersten Ende 3 und dem zweiten Ende 4 ist ein in einer Richtung parallel zur elektronischen Baugruppe BG und zur Leiterplatte PCB verformbarer Bereich 5 angeordnet, der hier durch einen in einer Ebene hin- und herverlaufend angeordneten Leiterabschnitt 9 gebildet ist. Durch diesen verformbaren Bereich 5 bzw. Leiterabschnitt 9 wird eine Verschiebung des zweiten Endes 4 gegenüber dem ersten Ende 3 des Kontaktelements 2, also in x- und y-Richtung ermöglicht.

Das Kontaktelement 2 ist durch eine Einhausung 6 aus elektrisch isolierendem Material umgeben, beispielsweise umspritzt. Die Einhausung 6 ist zur Fixierung des ersten Endes 3 des Kontaktelements 2 ausgebildet und in einer Richtung parallel zur elektronischen Baugruppe BG und der Leiterplatte PCB, also in einer durch die x-Richtung und y-Richtung aufgespannte Ebene verschiebbar. In z-Richtung, also einer Richtung senkrecht zur elektronischen Baugruppe BG und Leiterplatte PCB ist das Kontaktelement 2 vorzugsweise fixiert, um die Kontaktierung des zweiten Endes 4 des Kontaktelements 2 in der Durchgangsbohrung DB der Leiterplatte PCB zu erleichtern. Zum Zweck der Fixierung des zweiten Endes 4 des Kontaktelements 2 können die unterhalb des komprimierbaren Kopfes 11 üblicherweise abstehenden Schultern am Kontaktelement 2 von der Einhausung 6 umspritzt oder in geeigneter Weise in einer Aufnahme 8 der Einhausung 6 angeordnet sein.

Weiters ist an der Einhausung 6 des Kontaktelements 2 ein über das zweite Ende 4 des Kontaktelements 2 überstehendes Positionierelement 7 beispielsweise in Form eines Positionierstiftes 16 angeordnet. Dieser Positionierstift 16 dient zur Anordnung in einer entsprechenden Positionieröffnung PO in der Leiterplatte PCB während des Kontaktiervorgangs. Dabei sollte das Positionierelement 7 das zweite Ende 4 des Kontaktelements 2 so weit überragen, dass die gewünschte Lage des Kontaktelements 2 durch Anordnung des Positionierelements 7 bzw. Positionierstifts 16 in der Positionieröffnung PO rechtzeitig erreicht wird, bevor das Ende 4 des Kontaktelements 2 in der Durchgangsbohrung DB der Leiterplatte PCB auftrifft. Zum Zweck der eindeutigen Orientierung des Kontaktierungssystems 1 in Bezug auf die Leiterplatte PCB weist der Positionierstift 16 beispielsweise eckigen Querschnitt auf, der eine Verdrehung des Positionierstiftes 16 in der Positionieröffnung PO verhindert.

Während der Kontaktierung der Leiterplatte PCB mit dem zweiten Ende 4 des Kontaktelements 2 wird die Leiterplatte PCB gegen die z-Richtung zur elektronischen Baugruppe BG und/oder die elektronische Baugruppe BG zur Leiterplatte PCB bewegt, wodurch der Positionierstift 16 in die entsprechend angeordnete Positionieröffnung PO in der Leiterplatte PCB ragt. Die Positionieröffnung PO ist entsprechend dem Querschnitt des Positionierstifts 16, also beispielsweise eckig, und vorzugsweise zusammenlaufend ausgebildet. Dadurch wird das Positionierelement 7 in die Positionieröffnung PO gezwungen und während der Bewegung in Richtung elektronische Baugruppe BG gegebenenfalls das zweite Ende 4 des Kontaktelements 2 gegenüber dem ersten Ende 3 des Kontaktelements 2 (hier entgegen der x-Richtung) verschoben. Dabei wird der verformbare Bereich 5 des Kontaktelements 2 gestreckt, bis das zweite Ende 4 des Kontaktelements 2 in die Durchgangsbohrung DB in der Leiterplatte PCB passt. Schließlich wird der komprimierbare Kopf 11 am zweiten Ende 4 des Kontaktelements 2 vollständig von der Durchgangsbohrung DB aufgenommen und es findet eine einwandfreie Kontaktierung zwischen der Leiterplatte PCB und der elektronischen Baugruppe BG über das Kontaktelement 2 statt. Dieser Zustand ist in Fig. 5 dargestellt.

Das Kontaktierungssystem 1 kann natürlich auch umgekehrt angeordnet sein und zur selbstjustierenden Kontaktierung der elektronischen Baugruppe BG mit auf einer Leiterplatte PCB angeordneten Kontaktelementen 2 ausgebildet sein, in welchem Fall die Einhausung 6 am ersten Ende 3 des Kontaktelements 2 fixiert ist und die Positionierelemente 7 über das erste Ende 3 des Kontaktierungssystems 1 überstehen und in entsprechende Positionieröffnungen PO in der elektronischen Baugruppe angeordnet werden (nicht dargestellt).

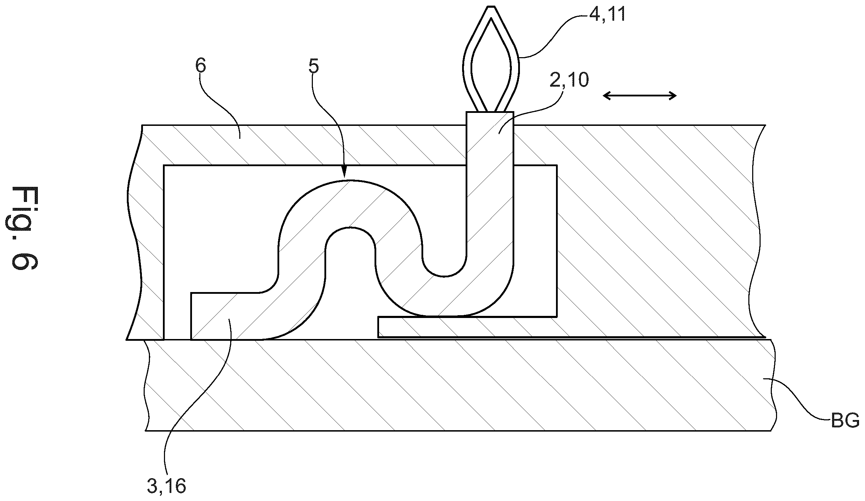

Fig. 6 zeigt ein Detail der Einhausung 6 eines Kontaktelements 2 in Form eines Press-Fit-Pins 10 in geschnittener Darstellung. Die Einhausung 6 aus elektrisch isolierendem Material fixiert das zweite Ende 4 des Kontaktelements 2. Zusätzlich isoliert die Einhausung 6 das Kontaktelement 2 im Bereich des verformbaren Bereichs 5 gegenüber der elektronischen Baugruppe BG, welche elektrisch leitend ausgebildet sein kann. Die Einhausung 6 kann also entsprechend der Gestalt des verformbaren Bereichs 5 des Kontaktelements 2 ausgebildet werden, um eine zusätzliche Funktion einer Isolierung gegenüber der elektronischen Baugruppe BG zu bewirken.

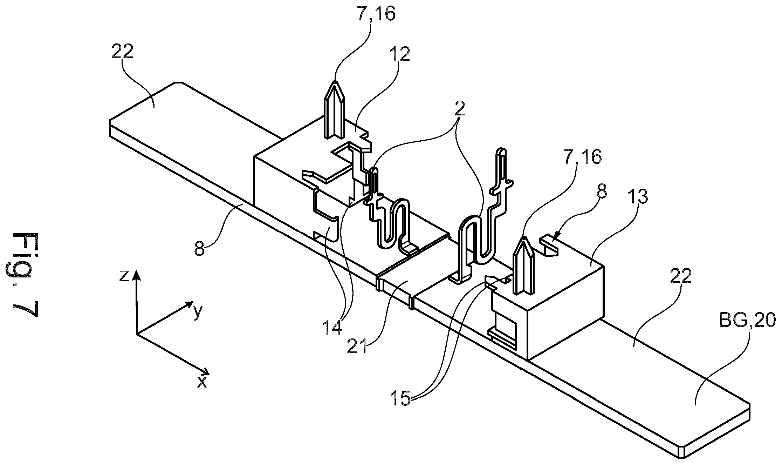

Fig. 7 ist eine Ausführungsform eines erfindungsgemäßen Kontaktierungssystems 1 mit zwei Kontaktelementen 2. Die Kontaktelemente 2 sind durch Press-Fit-Pins 10 mit jeweils einem komprimierbaren Kopf 11 am zweiten Ende 4 und einem abgeflachten Fuß 18 am ersten Ende 3 gebildet. Bei dieser Variante ist die Einhausung 6 aus zwei miteinander verbindbaren Teilen 12, 13 aufgebaut, um die Fixierung der Kontaktelemente 2 am zweiten Ende 4 zu erleichtern. Die beiden Teile 12, 13 der Einhausung 6 werden vorzugsweise über Rastelemente 14, 15 werkzeuglos miteinander verbunden. An jedem Teil 12, 13 der Einhausung 6 ist ein Positionierelement 7 in Form eines Positionierstifts 16 angeordnet, der jeweils über das zweite Ende 4 der Kontaktelemente 2 übersteht.

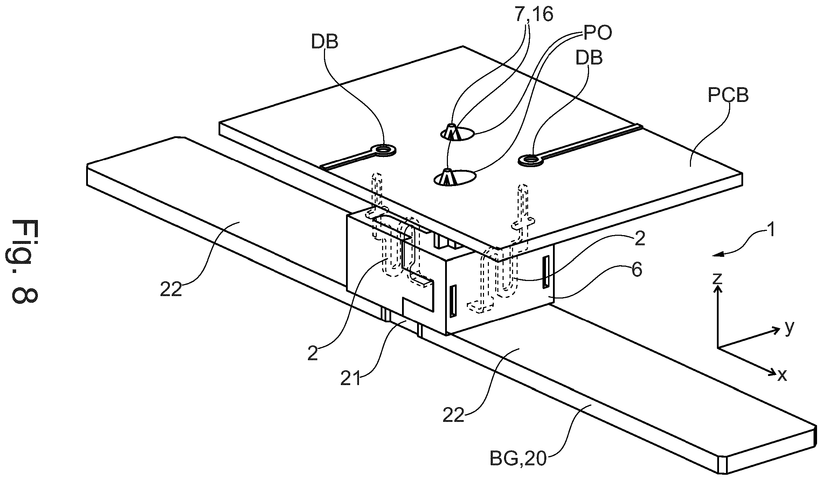

Fig. 8 zeigt das Kontaktierungssystem 1 gemäß Fig. 7 vor dem Kontaktiervorgang bei zusammengesteckten Teilen 12, 13 der Einhausung 6. Die Positionierstifte 16 der Einhausung 6 ragen mit der Spitze in entsprechende Positionieröffnungen PO in der Leiterplatte PCB. Dabei ist die linke Positionieröffnung PO in Form einer vorzugsweise zusammenlaufenden kreisrunden Öffnung und die rechte Positionieröffnung PO in Form eines nach oben zusammenlaufenden Langlochs ausgebildet, um eine entsprechende Bewegung der beiden Positionierstifte 16 in x- und y-Richtung zu ermöglichen.

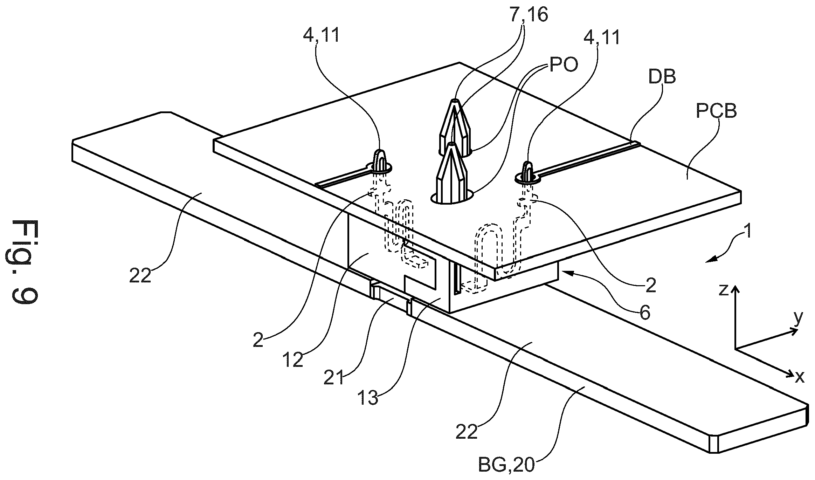

In Fig. 9 ist das Kontaktierungssystem 1 gemäß Fig. 7 beim Kontaktieren der Leiterplatte PCB mit der elektronischen Baugruppe BG gezeigt. Durch die Ausrichtung der Positionierstifte 16 der Einhausung 6 in den entsprechenden Positionieröffnungen PO der Leiterplatte PCB werden die zweiten Enden 4 der Kontaktelemente 2 in die dafür vorgesehenen Durchgangsbohrungen DB in der Leiterplatte PCB "gezwungen" und die Kontaktierung kann auch bei toleranzbedingten Abweichungen erfolgreich vorgenommen werden. Gegebenenfalls werden die verformbaren Bereiche 5 der Kontaktelemente 2 entsprechend gestreckt oder auch gestaucht und die zweiten Enden 4 der Kontaktelemente 2 gegenüber den auf der elektronischen Baugruppe BG fixierten ersten Enden 3 der Kontaktelemente 2 in der durch die x-Richtung und y-Richtung eingeschlossenen Ebene verschoben.

Bei der elektronischen Baugruppe BG kann es sich beispielsweise um einen Messwiderstand 20 oder Shunt handeln, der aus einem Präzisionswiderstand 21 und beiderseits mit dem Präzisionswiderstand 21 verbundenen Leiterelementen 22 besteht. Über zwei Kontaktelemente 2 des oben beschriebenen Kontaktierungssystems 1 wird dieser Messwiderstand 20 mit einer Leiterplatte PCB verbunden. Die elektronische Schaltung auf der Leiterplatte PCB wertet beispielsweise den Spannungsabfall, der an den beiden Kontaktelementen 2 am Präzisionswiderstand 21 abfällt, aus und kann daraus auf den durch den Messwiderstand 20 fließenden Strom rückschließen.

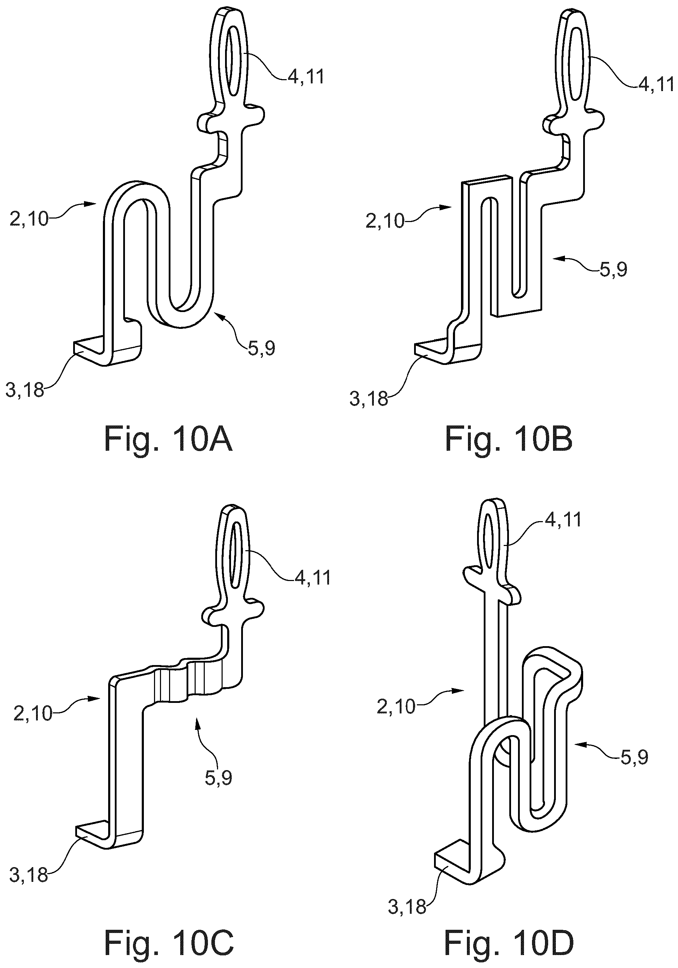

Schließlich zeigen die Fig. 10A bis 10D verschiedene Ausführungsvarianten von Kontaktelementen 2 mit verformbaren Bereichen 5 zwischen den Enden 3, 4. Bei der Ausführungsvariante des Kontaktelements 2 gemäß Fig. 10A handelt es sich um einen Press-Fit-Pin 10 mit einem ersten Ende 3 in Form eines abgeflachten Fußes 18 und einem zweiten Ende 4 in Form eines komprimierbaren Kopfes 11. Der verformbare Bereich 5 zwischen dem ersten Ende 3 und dem zweiten Ende 4 des Kontaktelements ist durch einen abgerundeten mäanderförmigen Leiterabschnitt 9 in einer Ebene senkrecht zur elektronischen Baugruppe BG und Leiterplatte PCB (nicht dargestellt), gebildet.

Die Ausführungsvariante des Kontaktelements 2 gemäß Fig. 10B unterscheidet sich von jener gemäß Fig. 10A dadurch, dass der mäanderförmige Leiterabschnitt 9 zur Bildung des verformbaren Bereichs 5 des Kontaktelements 2 nicht abgerundet sondern eckig verläuft.

Bei der Ausführungsvariante des Kontaktelements 2 gemäß Fig. 10C ist der Leiterabschnitt in einer Ebene parallel zur elektronischen Baugruppe BG und Leiterplatte PCB wellenförmig angeordnet, wodurch sich eine Verformbarkeit des Kontaktelements 2 in einer Richtung parallel zur elektronischen Baugruppe BG und Leiterplatte PCB ergibt.

Das Kontaktelement 2 gemäß Fig. 10D weist einen verformbaren Bereich 5 in zwei im Wesentlichen senkrecht zueinander stehenden Ebenen auf bzw. zwei verformbare Bereiche 5, welche jeweils durch abgerundete mäanderförmige Leiterabschnitte 9 gebildet sind. Dadurch wird eine Verschiebbarkeit des zweiten Endes 4 des Kontaktelements 2 gegenüber dem ersten Ende 3 des Kontaktelements 2 in x-Richtung oder y-Richtung (siehe Koordinatensystem in den Figuren 4 und 5) erzielt.

Das Kontaktierungssystem 1 gemäß der vorliegenden Erfindung erleichtert eine Kontaktierung einer elektronischen Baugruppe BG mit einer Leiterplatte PCB über zumindest ein Kontaktelement 2 bei festgelegten oder fixierten Positionen der elektronischen Baugruppe BG und der Leiterplatte PCB auch bei toleranzbedingten geometrischen Abweichungen der Kontaktelemente 2 sowie elektronischen Baugruppe BG und Leiterplatte PCB. Dadurch wird insbesondere eine automatisch vorgenommene Kontaktierung durch Manipulationsroboter besonders unterstützt. Aber auch bei manuell durchgeführten Kontaktierungen weist die vorliegende Erfindung Vorteile auf.

## Patentansprüche

1. Kontaktierungssystem (1) zur Kontaktierung einer elektronischen Baugruppe (BG) mit einer Leiterplatte (PCB), mit zumindest einem Kontaktelement (2) mit jeweils einem ersten Ende (3) zur Verbindung mit der elektronischen Baugruppe (BG) und jeweils einem zweiten Ende (4) zur Verbindung mit der Leiterplatte (PCB), wobei das zumindest eine Kontaktelement (2) zwischen dem ersten Ende (3) und dem zweiten Ende (4) einen in einer Richtung parallel zur elektronischen Baugruppe (BG) und der Leiterplatte (PCB) verformbaren Bereich (5) aufweist, zur Erzielung einer Verschiebbarkeit des ersten Endes (3) relativ zum zweiten Ende (4) des Kontaktelements (2) in einer Richtung parallel zur elektronischen Baugruppe (BG) und der Leiterplatte (PCB), **dadurch gekennzeichnet, dass** das zumindest eine Kontaktelement (2) von einer Einhausung (6) aus elektrisch isolierendem Material umgeben und zur Fixierung des ersten Endes (3) oder zweiten Endes (4) des Kontaktelements (2) ausgebildet ist und in einer Richtung parallel zur elektronischen Baugruppe (BG) und der Leiterplatte (PCB) verschiebbar ist, und an der Einhausung (6) zumindest ein über das erste Ende (3) oder das zweite Ende (4) jedes Kontaktelements (2) überstehendes Positionierelement (7) zur Anordnung in zumindest einer entsprechenden Positionieröffnung (PO) in der Leiterplatte (PCB) oder der elektronischen Baugruppe (BG) angeordnet ist.

2. Kontaktierungssystem (1) nach Anspruch 1, **dadurch gekennzeichnet, dass** jedes Kontaktelement (2) in einer Richtung (z) senkrecht zur elektronischen Baugruppe (BG) und Leiterplatte (PCB) fixiert ist.

3. Kontaktierungssystem (1) nach Anspruch 2, **dadurch gekennzeichnet, dass** die Einhausung (6) eine Aufnahme (8) zur Fixierung des ersten Endes (3) oder zweiten Endes (4) des Kontaktelements (2) aufweist.

4. Kontaktierungssystem (1) nach einem der Ansprüche 1 bis 3, **dadurch gekennzeichnet, dass** der verformbare Bereich (5) jedes Kontaktelements (2) durch einen in zumindest einer Ebene hin- und herverlaufend angeordneten Leiterabschnitt (9), vorzugsweise einem in zumindest einer Ebene mäanderförmig oder zick-zack-förmig verlaufenden Leiterabschnitt (9), gebildet ist, wodurch eine Verschiebbarkeit in zumindest einer Richtung parallel zur elektronischen Baugruppe (BG) und der Leiterplatte (PCB) erzielbar ist.

5. Kontaktierungssystem (1) nach einem der Ansprüche 1 bis 4, **dadurch gekennzeichnet, dass** die Kontaktelemente (2) durch Press-Fit-Pins (10) mit einem komprimierbaren Kopf (11) an zumindest einem Ende (3, 4) gebildet sind.

6. Kontaktierungssystem (1) nach einem der Ansprüche 1 bis 5, **dadurch gekennzeichnet, dass** die Einhausung (6) zumindest aus zwei miteinander verbindbaren Teilen (12, 13) besteht, welche Teile (12, 13) vorzugsweise über Rastelemente (14, 15) werkzeuglos miteinander verbindbar sind.

7. Kontaktierungssystem (1) nach einem der Ansprüche 1 bis 6, **dadurch gekennzeichnet, dass** das zumindest eine Positionierelement (7) durch zumindest einen Positionierstift (16) mit vorzugsweise eckigem Querschnitt gebildet ist.

8. Kontaktierungssystem (1) nach einem der Ansprüche 1 bis 6, **dadurch gekennzeichnet, dass** das zumindest eine Positionierelement (7) durch zumindest zwei Positionierstifte (16) mit vorzugsweise rundem Querschnitt gebildet ist.

9. Kontaktierungssystem (1) nach einem der Ansprüche 1 bis 8, **dadurch gekennzeichnet, dass** die Einhausung (6) vorzugsweise zusammen mit den Positionierelementen (7) aus Kunststoff, insbesondere aus thermoplastischem Kunststoff, hergestellt ist.

10. Kontaktierungssystem (1) nach einem der Ansprüche 1 bis 9, **dadurch gekennzeichnet, dass** das erste Ende (3) eines Kontaktelements (2) durch einen abgeflachten Fuß (18) zur Verbindung mit der elektronischen Baugruppe (BG), vorzugsweise durch Schweißen oder Löten, gebildet ist.

11. Kontaktierungssystem (1) nach einem der Ansprüche 1 bis 10, **dadurch gekennzeichnet, dass** das erste Ende (3) eines Kontaktelements (2) und bzw. oder das zweite Ende (4) eines Kontaktelements (2) durch einen Lötpin zur Kontaktierung mit der elektronischen Baugruppe (BG) und bzw. oder der Leiterplatte (PCB), vorzugsweise durch Schweißen oder Löten, gebildet ist.

12. Kontaktierungssystem (1) nach einem der Ansprüche 1 bis 11, **dadurch gekennzeichnet, dass** das erste Ende (3) eines Kontaktelements (2) und bzw. oder das zweite Ende (4) eines Kontaktelements (2) durch einen komprimierbaren Kopf (11)zur automatischen Kontaktierung in entsprechenden Durchgangsbohrungen (DB) in der elektronischen Baugruppe (BG) und bzw. oder der Leiterplatte (PCB) gebildet ist.

13. Messwiderstand (20) mit einem Präzisionswiderstand (21) und beiderseits mit dem Präzisionswiderstand (21) verbundenen Leiterelementen (22) und einem Kontaktierungssystem (1) nach einem der Ansprüche 1 bis 12, **dadurch gekennzeichnet, dass** zwei Kontaktelemente (2) mit ihrem ersten Ende (3) mit den Leiterelementen (22) des Präzisionswiderstands (21) verbunden sind und mit ihrem zweiten Ende (4) mit Durchgangsbohrungen (DB) einer Leiterplatte (PCB) kontaktierbar sind.

14. Messwiderstand (20) nach Anspruch 13, **dadurch gekennzeichnet, dass** die Kontaktelemente (2) mit ihrem ersten Ende (3) in Form eines abgeflachten Fußes (18) oder Lötpins mit den Leiterelementen (22) verschweißt oder verlötet sind.

15. Messwiderstand (20) nach Anspruch 13 oder 14, **dadurch gekennzeichnet, dass** die Kontaktelemente (2) mit ihrem ersten Ende (3) in Form eines komprimierbaren Kopfes (11) eines Press-Fit-Pins (10) mit Durchgangsbohrungen (DB) in den Leiterelementen (20) verbindbar sind.

## Claims

1. A contacting system (1) for contacting an electronic assembly (BG) with a printed circuit board (PCB), comprising at least one contact element (2) each having a first end (3) for connection to the electronic assembly (BG) and each having a second end (4) for connection to the printed circuit board (PCB), wherein the at least one contact element (2) comprises, between the first end (3) and the second end (4), a deformable region (5) that is deformable in a direction parallel to the electronic assembly (BG) and the printed circuit board (PCB), for achieving a displaceability of the first end (3) relative to the second end (4) of the contact element (2) in a direction parallel to the electronic assembly (BG) and the printed circuit board (PCB), **characterized in that** the at least one contact element (2) is surrounded by a housing (6) made of electrically insulating material, which is configured for fixing the first end (3) or second end (4) of the contact element (2) and is displaceable in a direction parallel to the electronic assembly (BG) and the printed circuit board (PCB), and arranged on the housing (6) is at least one positioning element (7) protruding beyond the first end (3) or the second end (4) of each contact element (2) for arrangement in at least one corresponding positioning opening (PO) in the printed circuit board (PCB) or the electronic assembly (BG).

2. The contacting system (1) according to claim 1, **characterized in that** each contact element (2) is fixed in a direction (z) perpendicular to the electronic assembly (BG) and printed circuit board (PCB).

3. The contacting system (1) according to claim 2, **characterized in that** the housing (6) has a receptacle (8) for fixing the first end (3) or second end (4) of the contact element (2).

4. The contacting system (1) according to any one of claims 1 to 3, **characterized in that** the deformable region (5) of each contact element (2) is formed by a conductor section (9) arranged to run back and forth in at least one plane, preferably a conductor section (9) running in a meandering or zigzag shape in at least one plane, whereby a displaceability in at least one direction parallel to the electronic assembly (BG) and the printed circuit board (PCB) can be achieved.

5. The contacting system (1) according to any one of claims 1 to 4, **characterized in that** the contact elements (2) are formed by press-fit pins (10) having a compressible head (11) at at least one end (3, 4).

6. The contacting system (1) according to any one of claims 1 to 5, **characterized in that** the housing (6) consists of at least two parts (12, 13) connectable to one another, which parts (12, 13) are connectable to one another toollessly, preferably via latching elements (14, 15).

7. The contacting system (1) according to any one of claims 1 to 6, **characterized in that** the at least one positioning element (7) is formed by at least one positioning pin (16) having a preferably angular cross-section.

8. The contacting system (1) according to any one of claims 1 to 6, **characterized in that** the at least one positioning element (7) is formed by at least two positioning pins (16) having a preferably round cross-section.

9. The contacting system (1) according to any one of claims 1 to 8, **characterized in that** the housing (6), preferably together with the positioning elements (7), is made of plastic, in particular of thermoplastic material.

10. The contacting system (1) according to any one of claims 1 to 9, **characterized in that** the first end (3) of a contact element (2) is formed by a flattened foot (18) for connection to the electronic assembly (BG), preferably by welding or soldering.

11. The contacting system (1) according to any one of claims 1 to 10, **characterized in that** the first end (3) of a contact element (2) and/or the second end (4) of a contact element (2) is formed by a solder pin for contacting with the electronic assembly (BG) and/or the printed circuit board (PCB), preferably by welding or soldering.

12. The contacting system (1) according to any one of claims 1 to 11, **characterized in that** the first end (3) of a contact element (2) and/or the second end (4) of a contact element (2) is formed by a compressible head (11) for automatic contacting in corresponding through-holes (DB) in the electronic assembly (BG) and/or the printed circuit board (PCB).

13. A measuring resistor (20) comprising a precision resistor (21) and conductor elements (22) connected on both sides to the precision resistor (21) and a contacting system (1) according to any one of claims 1 to 12, **characterized in that** two contact elements (2) are connected at their first end (3) to the conductor elements (22) of the precision resistor (21) and are contactable at their second end (4) with through-holes (DB) of a printed circuit board (PCB).

14. The measuring resistor (20) according to claim 13, **characterized in that** the contact elements (2), with their first end (3) in the form of a flattened foot (18) or solder pin, are welded or soldered to the conductor elements (22).

15. The measuring resistor (20) according to claim 13 or 14, **characterized in that** the contact elements (2), with their first end (3) in the form of a compressible head (11) of a press-fit pin (10), are connectable to through-holes (DB) in the conductor elements (20).

## Revendications

1. Système de contact (1) destiné à la mise en contact d'un ensemble électronique (BG) avec une carte de circuit imprimé (PCB), comprenant au moins un élément de contact (2) présentant respectivement une première extrémité (3) pour la liaison avec l'ensemble électronique (BG) et respectivement une deuxième extrémité (4) pour la liaison avec la carte de circuit imprimé (PCB), dans lequel l'au moins un élément de contact (2) présente, entre la première extrémité (3) et la deuxième extrémité (4), une zone déformable (5) dans une direction parallèle à l'ensemble électronique (BG) et à la carte de circuit imprimé (PCB), pour obtenir une capacité de déplacement de la première extrémité (3) par rapport à la deuxième extrémité (4) de l'élément de contact (2) dans une direction parallèle à l'ensemble électronique (BG) et à la carte de circuit imprimé (PCB), **caractérisé en ce que** l'au moins un élément de contact (2) est entouré par un boîtier (6) en matériau électriquement isolant et est conçu pour la fixation de la première extrémité (3) ou de la deuxième extrémité (4) de l'élément de contact (2) et est déplaçable dans une direction parallèle à l'ensemble électronique (BG) et à la carte de circuit imprimé (PCB), et au moins un élément de positionnement (7) faisant saillie au-delà de la première extrémité (3) ou de la deuxième extrémité (4) de chaque élément de contact (2) est disposé sur le boîtier (6) pour l'agencement dans au moins une ouverture de positionnement (PO) correspondante dans la carte de circuit imprimé (PCB) ou l'ensemble électronique (BG).

2. Système de contact (1) selon la revendication 1, **caractérisé en ce que** chaque élément de contact (2) est fixé dans une direction (z) perpendiculaire à l'ensemble électronique (BG) et à la carte de circuit imprimé (PCB).

3. Système de contact (1) selon la revendication 2, **caractérisé en ce que** le boîtier (6) présente un logement (8) pour la fixation de la première extrémité (3) ou de la deuxième extrémité (4) de l'élément de contact (2).

4. Système de contact (1) selon l'une des revendications 1 à 3, **caractérisé en ce que** la zone déformable (5) de chaque élément de contact (2) est formée par un tronçon de conducteur (9) disposé de manière à s'étendre en va-et-vient dans au moins un plan, de préférence un tronçon de conducteur (9) s'étendant en forme de méandres ou en zigzag dans au moins un plan, moyennant quoi une capacité de déplacement dans au moins une direction parallèle à l'ensemble électronique (BG) et à la carte de circuit imprimé (PCB) peut être obtenue.

5. Système de contact (1) selon l'une des revendications 1 à 4, **caractérisé en ce que** les éléments de contact (2) sont formés par des broches de type « press-fit » (10) présentant une tête compressible (11) à au moins une extrémité (3, 4).

6. Système de contact (1) selon l'une des revendications 1 à 5, **caractérisé en ce que** le boîtier (6) est constitué d'au moins deux parties (12, 13) pouvant être reliées l'une à l'autre, lesquelles parties (12, 13) peuvent de préférence être reliées l'une à l'autre sans outil par l'intermédiaire d'éléments d'encliquetage (14, 15).

7. Système de contact (1) selon l'une des revendications 1 à 6, **caractérisé en ce que** l'au moins un élément de positionnement (7) est formé par au moins un pion de positionnement (16) présentant une section transversale de préférence angulaire.

8. Système de contact (1) selon l'une des revendications 1 à 6, **caractérisé en ce que** l'au moins un élément de positionnement (7) est formé par au moins deux pions de positionnement (16) présentant une section transversale de préférence ronde.

9. Système de contact (1) selon l'une des revendications 1 à 8, **caractérisé en ce que** le boîtier (6), de préférence conjointement avec les éléments de positionnement (7), est fabriqué en matière plastique, en particulier en matière plastique thermoplastique.

10. Système de contact (1) selon l'une des revendications 1 à 9, **caractérisé en ce que** la première extrémité (3) d'un élément de contact (2) est formée par un pied aplati (18) pour la liaison avec l'ensemble électronique (BG), de préférence par soudage ou brasage.

11. Système de contact (1) selon l'une des revendications 1 à 10, **caractérisé en ce que** la première extrémité (3) d'un élément de contact (2) et/ou la deuxième extrémité (4) d'un élément de contact (2) est formée par une broche à braser pour la mise en contact avec l'ensemble électronique (BG) et/ou la carte de circuit imprimé (PCB), de préférence par soudage ou brasage.

12. Système de contact (1) selon l'une des revendications 1 à 11, **caractérisé en ce que** la première extrémité (3) d'un élément de contact (2) et/ou la deuxième extrémité (4) d'un élément de contact (2) est formée par une tête compressible (11) pour la mise en contact automatique dans des perçages traversants (DB) correspondants dans l'ensemble électronique (BG) et/ou la carte de circuit imprimé (PCB).

13. Résistance de mesure (20) comprenant une résistance de précision (21) et des éléments conducteurs (22) reliés des deux côtés à la résistance de précision (21) et un système de contact (1) selon l'une des revendications 1 à 12, **caractérisée en ce que** deux éléments de contact (2) sont reliés par leur première extrémité (3) aux éléments conducteurs (22) de la résistance de précision (21) et peuvent être mis en contact par leur deuxième extrémité (4) avec des perçages traversants (DB) d'une carte de circuit imprimé (PCB).

14. Résistance de mesure (20) selon la revendication 13, **caractérisée en ce que** les éléments de contact (2) sont soudés ou brasés aux éléments conducteurs (22) par leur première extrémité (3) se présentant sous la forme d'un pied aplati (18) ou d'une broche à braser.

15. Résistance de mesure (20) selon la revendication 13 ou 14, **caractérisée en ce que** les éléments de contact (2) peuvent être reliés à des perçages traversants (DB) dans les éléments conducteurs (20) par leur première extrémité (3) se présentant sous la forme d'une tête compressible (11) d'une broche de type « press-fit » (10).
